# EUROPÄISCHE PATENTSCHRIFT

(11) **EP 2 207 344 B1**
(45) Veröffentlichungstag und Bekanntmachung des Hinweises auf die Patenterteilung: **15.02.2017**
(21) Anmeldenummer: 09015136.6
(22) Anmeldetag: 07.12.2009
(51) Int. Cl.: H04N 5/378, H04N 5/335, H01L 27/146

(54) **Bildsensor**
Image sensor
Capteur d'images

(30) Priorität: 13.01.2009 DE 102009004409
(43) Veröffentlichungstag der Anmeldung: 14.07.2010
(73) Patentinhaber: Arnold & Richter Cine Technik GmbH & Co. Betriebs KG, 80799 München (DE)
(72) Erfinder: Cieslinski, Michael, 85521 Ottobrunn (DE)
(74) Vertreter: Manitz, Finsterwald & Partner GbR

(56) Entgegenhaltungen:
- US-A- 4 644 411
- US-A- 5 299 013
- US-A1- 2003 029 989
- US-A1- 2006 220 673

## Beschreibung

Die vorliegende Erfindung betrifft einen Bildsensor für elektronische Kameras, insbesondere digitale Kinokameras, umfassend eine Vielzahl von lichtempfindlichen Pixeln zur Erzeugung von belichtungsproportionalen Signalen und wenigstens eine mit den Pixeln gekoppelte Ausleseschaltung mit einem ersten Abschnitt und mit einem dem ersten Abschnitt in einer Signalausleserichtung nachgeschalteten zweiten Abschnitt, wobei der erste Abschnitt und der zweite Abschnitt der Ausleseschaltung jeweils mit wenigstens einem zur Versorgung mit einer Betriebsspannung vorgesehenen Bondpad und/oder mit wenigstens einem zur Versorgung mit einem Referenzpotential vorgesehenen Bondpad verbunden sind.

Bekannte elektronische Kameras verwenden typischerweise einen Bildsensor in CMOS- oder CCD-Technologie, der eine Vielzahl von beispielsweise in Zeilen und Spalten angeordneten lichtempfindlichen Elementen - sogenannte Pixel - umfasst, die durch ein Objektiv der Kamera fallendes Licht in elektrische Signale umwandeln. Bei den Signalen kann es sich - insbesondere abhängig von der verwendeten Technologie und/oder der Verarbeitungsstufe auf dem Bildsensor - beispielsweise um Ladungen, Ströme oder Spannungen handeln. Ein jeweiliges Signal ist dabei zu einer durch eine Belichtung gesammelten Ladung des jeweiligen Pixels proportional.

Eine Ausleseschaltung, die üblicherweise am Rand des Bildsensors angeordnet ist, nimmt die Signale der Pixel zur weiteren Verarbeitung entgegen. Die Ausleseschaltung ist in der Regel in zwei voneinander verschiedene Abschnitte eingeteilt. Beispielsweise können in einem ersten Abschnitt der Ausleseschaltung die Signale der Pixel in elektrische Spannungen konvertiert und anschließend verstärkt werden, und in einem zweiten Abschnitt, der dem ersten Abschnitt in Signalausleserichtung nachgeschaltet ist, können die verstärkten Signale dann mittels eines Multiplexers an einem oder mehreren Ausgängen des Bildsensors analog ausgegeben oder mit einem oder mehreren internen Analog-Digital-Wandlern digitalisiert und digital ausgegeben werden.

Der Bildsensor umfasst üblicherweise eine Vielzahl von Ein- und Ausgängen für die einzelnen Schaltungsteile des Bildsensors, über die der Bildsensor mit externen Bauteilen oder Schaltungen kommunizieren kann, beispielsweise zum Empfangen von Steuersignalen und/oder zum Ausgeben der ggf. verstärkten Pixelsignale. Darüber hinaus sind auch Eingänge vorgesehen, die zur Versorgung des Bildsensors mit einer Betriebsspannung und/oder einem Referenzpotential, insbesondere Masse, dienen.

Der Bildsensor liegt üblicherweise zunächst in Form eines ungehäusten Halbleiter-Chips oder Dies vor. Um den Bildsensor mit den elektrischen Anschlüssen beispielsweise eines Gehäuses für den Bildsensor oder direkt mit einem anderen Halbleiter-Chip über Bonddrähte zu verbinden, umfasst der Bildsensor mit den vorgenannten Ein- und Ausgängen verbundene Bondpads, auf denen die Bonddrähte aufgesetzt werden können. Über die Bonddrähte kann der Bildsensor dann mit den externen Bauteilen oder Schaltungen kommunizieren bzw. mit der Betriebsspannung und/oder dem Referenzpotential versorgt werden.

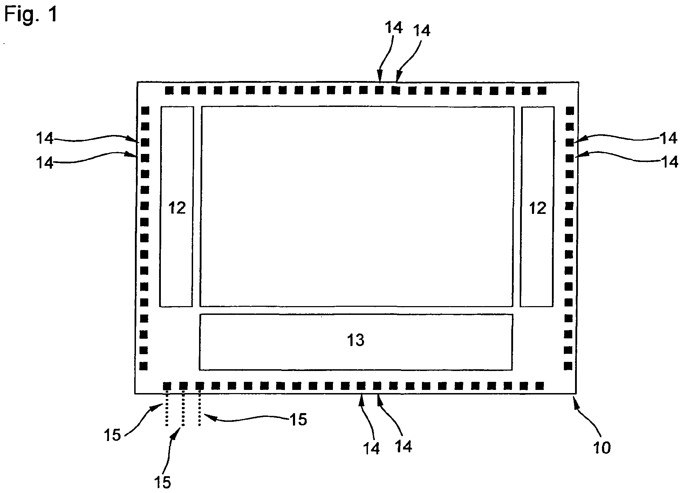

Fig. 1 zeigt einen aus dem Stand der Technik bekannten, in Form eines Halbleiter-Chips vorliegenden Bildsensor 10. Der Bildsensor 10 umfasst ein Bildfeld oder Pixelfeld 11, das aus einer Vielzahl von Pixeln (nicht gezeigt) besteht, die in Zeilen und Spalten (jeweils nicht gezeigt) angeordnet sind. Der Bildsensor kann beispielsweise 2000 Zeilen und 3000 Spalten aufweisen. Darüber hinaus umfasst der Bildsensor 10 eine Zeilenauswahlschaltung 12, durch die jeweils eine der Zeilen zum Auslesen der Signale der Pixel dieser Zeile ausgewählt werden kann. Die Zeilenauswahlschaltung 12 ist in der in Fig. 1 gezeigten Ausführungsform eines bekannten Bildsensors 10 zweigeteilt, wobei die beiden Teile der Zeilenauswahlschaltung 12 zu beiden Seiten des Bildfelds 11, d.h. in Längsrichtung der Zeilen, an das Bildfeld 11 angrenzen.

Außerdem umfasst der Bildsensor 10 gemäß Fig. 1 eine Ausleseschaltung 13, die in Fig. 1 unterhalb des Bildfelds 11 angeordnet ist. Die Ausleseschaltung 13 umfasst - aus Fig. 1 nicht erkennbar - einen ersten Abschnitt und einen zweiten Abschnitt, wie sie bereits vorstehend erläutert sind und nachstehend noch näher erläutert werden. Der zweite Abschnitt ist dem ersten Abschnitt in Signalausleserichtung nachgeschaltet. Die Signalausleserichtung ist dabei durch den Auslesepfad eines jeweiligen Signals eines Pixels gegeben, d.h. das in einem jeweiligen Pixel erzeugte Signal wird beim Auslesen zunächst in dem ersten Abschnitt der Ausleseschaltung verarbeitet und von dort an den zweiten Abschnitt weitergegeben.

Schließlich sind in Fig. 1 Bondpads 14 erkennbar, die üblicherweise am äußeren Rand des Bildsensors 10 und umlaufend, d.h. auf allen vier Seiten des Bildsensors 10, angeordnet sind. Die Bondpads 14 sind mit den vorgenannten Ein- und Ausgängen (nicht gezeigt) der einzelnen Schaltungsteile des Bildsensors 10 verbunden und ermöglichen, dass der Bildsensor 10 über Bonddrähte 15, von denen in Fig. 1 nur einige beispielhaft dargestellt sind, mit anderen externen Bauteilen oder Schaltungen kommunizieren kann und mit der Betriebsspannung und/oder dem Referenzpotential versorgt werden kann.

Üblicherweise erfolgt das Auslesen der Signale der Pixel des Bildsensors 10 zeilenweise, d.h. Zeile für Zeile, um eine hohe Bildrate, d.h. eine hohe Geschwindigkeit zu erreichen, mit der ein Bild aus dem Sensor 10 ausgelesen werden kann. Es werden also die Signale aller Pixel einer jeweiligen Zeile simultan ausgelesen. Üblicherweise werden die Signale einer jeweiligen Zeile hierzu über Spaltenleitungen ausgelesen, in Sample-and-Hold-Schaltungen gespeichert und mittels Spaltenverstärkern verstärkt. Das Auslesen geschieht durch den ersten Abschnitt der Ausleseschaltung 13 und mit einer vorgegebenen Taktfrequenz, beispielsweise 200 kHz.

Die in dem ersten Abschnitt der Ausleseschaltung 13 vorliegenden Signale werden dann von dem zweiten Abschnitt weiterverarbeitet, und zwar üblicherweise mit einer Taktfrequenz, die höher ist als die Taktfrequenz des ersten Abschnitts, beispielsweise 50 MHz. Die Weiterverarbeitung besteht insbesondere darin, dass die durch den ersten Abschnitt ausgelesenen Signale einer jeweiligen Zeile mittels eines Multiplexers nacheinander an einem Ausgang der Ausleseschaltung 13 ausgegeben werden. Die Ausleseschaltung 13 kann jedoch ebenso mehrere Ausgänge umfassen, so dass gleichzeitig jeweils mehrere Signale einer jeweiligen Zeile ausgegeben werden können, d.h. es können auch Gruppen von Signalen einer jeweiligen Zeile nacheinander ausgegeben werden. Darüber hinaus kann in dem zweiten Abschnitt auch eine Analog-Digital-Wandlung und/oder eine Ausgangsverstärkung der ausgelesenen Signale stattfinden.

Um die Bildrate weiter zu erhöhen, weist der Bildsensor 10 üblicherweise eine sogenannte Pipeline-Architektur auf, d.h. das Auslesen der Signale der Pixel einer Zeile durch den ersten Abschnitt der Ausleseschaltung 13 erfolgt parallel zum Ausgeben der sich inzwischen in dem zweiten Abschnitt befindlichen Signale der Pixel der unmittelbar zuvor ausgelesenen Zeile.

Beim Auslesen der Signale der Pixel einer jeweiligen Zeile fließen in den vorgenannten Spaltenleitungen kurzzeitig, beispielsweise für ca. 100 ns, hohe Ströme, bis die Spaltenleitungen jeweils einen, der Höhe des jeweiligen Signals entsprechenden Pegel erreicht haben. Grundsätzlich fließen beim Auslesen eines Bildsensors 10 zu verschiedenen Zeitpunkten an verschiedenen Stellen der Ausleseschaltung 13 unterschiedlich hohe Ströme. Insbesondere benötigen die beiden Abschnitte der Ausleseschaltung 13 schwankende und/oder wechselnde Ströme und Stromspitzen aus der Spannungsversorgung.

Die Ausleseschaltung 13 des Bildsensors 10 weist üblicherweise einen hohen Integrationsgrad auf, d.h. eine hohe Vielzahl an elektronischen Bauelementen wie Transistoren und Kondensatoren. Die elektronischen Bauelemente sind über Leiterbahnen mit wenigstens einem zur Versorgung mit einer Betriebsspannung vorgesehenen Bondpad 14 und/oder mit wenigstens einem zur Versorgung mit einem Referenzpotential vorgesehenen Bondpad 14 verbunden.

Mit dem hohen Integrationsgrad der elektronischen Bauteile des Bildsensors 10 geht eine geringe Strukturgröße der elektronischen Bauteile einher, die auch für die Leiterbahnen des Bildsensors 10 gilt. Beispielsweise liegen Breite und Dicke einer Leiterbahn im Submicron-Bereich. Dadurch besitzen Leiterbahnen einen entsprechend hohen elektrischen Widerstand. Der hohe Leitungswiderstand des Versorgungsnetzes führt bei einem hohen Strombedarf der vorgenannten Bauelemente zu Spannungseinbrüchen auf der Versorgung und wegen des Stromrückflusses auch zu Schwankungen des Referenzpotentials.

Durch die vorgenannten Rückwirkungen eines schwankenden Strombedarfs auf die Betriebsspannung und/oder auf das Referenzpotential in Kombination mit der vorgenannten Realisierung des Bildsensors 10 in einer Pipeline-Architektur kann es daher zu gegenseitigen Störungen des Betriebs des ersten und des zweiten Abschnitts der Ausleseschaltung 13 kommen, die gerade auch durch den Betrieb mit unterschiedlichen Taktfrequenzen hervorgerufen werden können. Insbesondere Schwankungen des Bezugspotentials, das in der Regel über das im Vergleich zu metallischen Leiterbahnen hochohmige Substrat des Halbleiter-Chips bereitgestellt wird, können zu merklichen Störungen in dem jeweils anderen Abschnitt der Ausleseschaltung führen. Beispielsweise kann durch hohe Ströme in dem ersten Abschnitt der Ausleseschaltung das Verarbeiten der gerade in dem zweiten Abschnitt befindlichen Signale gestört werden.

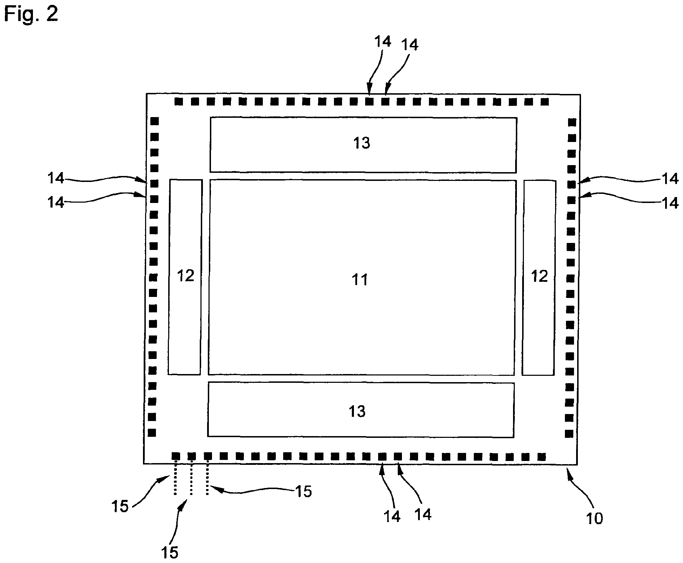

In Fig. 2 ist ein weiterer aus dem Stand der Technik bekannter Bildsensor 10 dargestellt, der sich gegenüber dem in Fig. 1 gezeigten Bildsensor 10 lediglich dadurch unterscheidet, dass die Ausleseschaltung 13 zweigeteilt ist, wobei ein Teil der Ausleseschaltung 13 oberhalb des Bildfelds 11 und ein Teil unterhalb des Bildfelds 11 angeordnet ist, und wobei jeder der beiden Teile einen vorgenannten ersten und zweiten Abschnitt besitzt. Dies ist insbesondere dann von Vorteil, wenn das Bildfeld 11 in eine obere Bildhälfte und eine untere Bildhälfte eingeteilt ist, und die obere Bildhälfte durch den oberen Teil der Ausleseschaltung 13 und die untere Bildhälfte durch den unteren Teil der Ausleseschaltung 13 ausgelesen wird. Hierdurch kann die Bildrate noch weiter erhöht werden, da jeweils zwei Zeilen, nämlich eine Zeile aus der oberen Bildhälfte des Bildfelds 11 und eine Zeile aus der unteren Bildhälfte, gleichzeitig ausgelesen werden können.

Ein Bildsensor mit den Merkmalen des Oberbegriffs des Anspruchs 1 ist aus dem Dokument US 4644411 A bekannt.

Das Dokument US 5299013 A offenbart einen Multi-Chip-Bildsensor, bei dem zwei Abschnitte der Ausleseschaltung auf zwei Chips verteilt sind.

Der Erfindung liegt die Aufgabe zugrunde, einen Bildsensor der eingangs genannten Art anzugeben, der eine Störung des Betriebs des ersten Abschnitts der Ausleseschaltung durch den Betrieb des zweiten Abschnitts und umgekehrt vermeidet.

Die Aufgabe wird durch einen Bildsensor mit den Merkmalen des Anspruchs 1 gelöst. Bei einem derartigen Bildsensor sind wenigstens einige, vorzugsweise sämtliche der zur Versorgung der Ausleseschaltung mit der Betriebsspannung und/oder dem Referenzpotential vorgesehenen Bondpads zwischen dem ersten Abschnitt und dem zweiten Abschnitt der Ausleseschaltung angeordnet.

Dadurch können Impulsströme, die bei einem Schalten in einem der beiden Abschnitte der Ausleseschaltung entstehen, über die zwischen den beiden Abschnitten angeordneten, zur Versorgung mit der Betriebsspannung und/oder dem Referenzpotential vorgesehenen Bondpads abgeführt werden, wodurch eine Beeinflussung des Betriebs des anderen der beiden Abschnitte der Ausleseschaltung nur noch in einem sehr viel geringerem Maße stattfindet. Die Bonddrähte besitzen nämlich einen wesentlich größeren Querschnitt als die Leiterbahnen auf dem Bildsensor und damit einen deutlich geringen elektrischen Widerstand, z.B. um einen Faktor 10. Beispielsweise weisen Bonddrähte einen Durchmesser von 32 µm auf, wohingegen die Dicke einer Leiterbahn auf dem Bildsensor lediglich 0,5 µm beträgt.

Durch die Anordnung von zur Versorgung mit der Betriebsspannung und/oder dem Referenzpotential vorgesehenen Bondpads zwischen den beiden Abschnitten kann daher eine weitgehende gegenseitige Abschirmung der beiden Abschnitte voneinander erreicht werden. Der Betrieb der beiden

Abschnitte der Ausleseschaltung ist somit zumindest weitgehend voneinander unbeeinflusst.

Darüber hinaus können durch die Anordnung von zur Versorgung mit der Betriebsspannung und/oder dem Referenzpotential vorgesehenen Bondpads zwischen den beiden Abschnitten die Längen der Leitungsbahnen zwischen den jeweiligen Bondpads und dem ersten und zweiten Abschnitt in beiden Fällen besonders kurz gehalten werden, so dass Rückwirkungen auf die Betriebsspannung und/oder auf das Referenzpotential von vornherein gering gehalten werden können.

Insbesondere liegen wenigstens einige der zur Versorgung der Ausleseschaltung mit der Betriebsspannung und/oder dem Referenzpotential vorgesehenen Bondpads nicht unmittelbar an einem Rand des Bildsensors. Bevorzugt sind wenigstens einige der zur Versorgung der Ausleseschaltung mit der Betriebsspannung und/oder dem Referenzpotential vorgesehenen Bondpads durch den zweiten Abschnitt der Ausleseschaltung von einem Rand des Bildsensors beabstandet oder getrennt, d.h. der zweite Abschnitt der Ausleseschaltung ist zwischen den betreffenden Bondpads und dem jeweiligen Rand des Bildsensors angeordnet.

Der erste Abschnitt und der zweite Abschnitt der Ausleseschaltung sind ansonsten üblicherweise wie vorstehend zum Stand der Technik erläutert ausgebildet. Bevorzugt sind die Pixel in wenigstens einer Zeile und in Spalten angeordnet, wobei der erste Abschnitt und der zweite Abschnitt der Ausleseschaltung jeweils sich über die gesamte Länge einer Zeile und/oder sämtliche Spalten erstrecken. Weiter bevorzugt sind die Pixel in einem eindimensionalen oder zweidimensionalen Bildfeld angeordnet, wobei der erste Abschnitt und der zweite Abschnitt der Ausleseschaltung auf derselben Seite des Bildfelds benachbart zueinander angeordnet sind.

Nach einer Ausführungsform der Erfindung sind der erste Abschnitt und/oder der zweite Abschnitt der Ausleseschaltung jeweils mit mehreren zur Versorgung mit der Betriebsspannung vorgesehenen Bondpads und/oder mit mehreren zur Versorgung mit dem Referenzpotential vorgesehenen Bondpads verbunden. Beispielsweise können für jeden der beiden Abschnitte der Ausleseschaltung diejenigen elektronischen Bauelemente, die jeweils beispielsweise für ca. 20 bis 50 Spalten eines Bildfelds vorgesehen sind, mit einem eigenen zur Versorgung mit einer Betriebsspannung vorgesehenen Bondpad und/oder mit einem eigenen zur Versorgung mit einem Referenzpotential vorgesehenen Bondpad verbunden sein. Dies ist insbesondere dann von Vorteil, wenn ein aufgenommenes Bild starke Helligkeitsunterschiede aufweist. Wird beispielsweise ein Bild einer Kerze in einem ansonsten dunklem Raum aufgenommen, besitzen beispielsweise Verstärker des ersten Abschnitts der Ausleseschaltung, die zu Spalten gehören, die im Bereich der Kerzenflamme liegen, eine hohe Stromaufnahme. Die hohe Stromaufnahme kann, insbesondere bei Übersteuerung der Verstärker, zu einer negativen Beeinflussung der Stabilität der Betriebsspannung und des Referenzpotentials führen. Diese Beeinflussung wiederum würde dann auf die elektronischen Bauelemente aller übrigen Spalten des Bildfelds, die an denselben Bondpads angeschlossen wären, derart durchschlagen, dass die Kerzenflamme als ein waagrechter heller Streifen durch das ansonsten dunkle Bild verlaufen würde, d.h. es würden auch Bildpunkte beeinflusst, die in einem großem Abstand zu der Kerzenflamme liegen. Durch die Vielzahl von zur Versorgung mit der Betriebsspannung vorgesehenen Bondpads und/oder zur Versorgung mit dem Referenzpotential vorgesehenen Bondpads kann eine derartige Beeinflussung auf einen lediglich lokalen Bereich beschränkt werden, so dass kein sich durch das gesamte Bild erstreckender horizontaler Streifen auftritt. Darüber hinaus können durch die Vielzahl von vorgenannten Bondpads Spannungsabfälle auf Leiterbahnen des Bildsensors reduziert werden.

Bevorzugt sind zumindest einige, insbesondere alle der zur Versorgung mit der Betriebsspannung und/oder dem Referenzpotential vorgesehenen Bondpads jeweils mit nur einem der beiden Abschnitte der Ausleseschaltung verbunden. Für die beiden Abschnitte der Ausleseschaltung sind also separate Bondpads vorgesehen. Den beiden Abschnitten wird die Betriebsspannung und/oder das Referenzpotential daher getrennt zugeführt. Hierdurch können Rückwirkungen des Betriebs des einen Abschnitts auf den Betrieb des anderen Abschnitts noch besser vermieden werden.

Die zur Versorgung mit der Betriebsspannung und/oder dem Referenzpotential vorgesehenen Bondpads können entlang einer insbesondere inneren Bondpadreihe angeordnet sein, wobei bevorzugt die einzelnen Bondpads zumindest im Wesentlichen äquidistant angeordnet sind. Dabei können sämtliche Bondpads der Bondpadreihe zur Versorgung mit der Betriebsspannung und/oder dem Referenzpotential vorgesehen sein.

Nach einer anderen Ausführungsform der Erfindung kann eine weitere, insbesondere äußere Bondpadreihe mit zumindest im Wesentlichen äquidistanten Bondpads vorgesehen sein. Insbesondere kann die weitere Bondpadreihe auf der von den Pixeln abgewandten Seite des zweiten Abschnitts der Ausleseschaltung angeordnet sein. Bevorzugt sind die beiden Bondpadreihen dann gegeneinander versetzt, so dass die Bonddrähte für die beiden Bondpadreihen nebeneinander angeordnet werden können und nicht übereinander verlaufen müssen.

Die beiden Bondpadreihen können dieselbe Bondpaddichte aufweisen. Es ist jedoch auch möglich, dass bei der inneren Bondpadreihe die Bondpads nur halb so dicht angeordnet sind. Auch dann können die Bonddrähte der inneren Reihe zwischen den Bondpads der äußeren Reihe geführt werden. Durch den größeren Abstand der Bondpads der inneren Bondpadreihe ist es leichter möglich, die Leitungen zu verlegen, die die beiden Abschnitte der Auswerteschaltung miteinander verbinden. Zudem ist auch eine vollkommen beliebige Anordnung der Bondpads der inneren Reihe möglich. Dann müssen die Bonddrähte, die die inneren Reihe kontaktieren, ggf. in einer anderen Ebene geführt werden, d.h. sie liegen dann beispielsweise oberhalb der Bonddrähte der äußeren Reihe.

Nach einer weiteren Ausführungsform der Erfindung sind zwei Ausleseschaltungen vorgesehen, die bezüglich der Pixel auf einander gegenüberliegenden Seiten angeordnet sind, die jeweils wie vorstehend erläutert ausgebildet sind, und die jeweils wie vorstehend erläutert mit Bondpads verbunden sind, wobei für jede Ausleseschaltung eigene Bondpads wie vorstehend erläutert vorgesehen sind.

Vorteilhafte Ausführungsformen der Erfindung sind auch in den Unteransprüchen, der Beschreibung und der Zeichnung angegeben.

Die Erfindung wird im Folgenden beispielhaft unter Bezugnahme auf die Zeichnung beschrieben, es zeigen, jeweils in schematischer Darstellung,
- Fig. 1: einen aus dem Stand der Technik bekannten Bildsensor mit einer einteiligen Ausleseschaltung,
- Fig. 2: einen weiteren aus dem Stand der Technik bekannten Bildsensor mit einer zweiteiligen Ausleseschaltung,
- Fig. 3: einen erfindungsgemäßen Bildsensor gemäß einer ersten Ausführungsform mit einer einteiligen Ausleseschaltung,
- Fig. 4: einen erfindungsgemäßen Bildsensor gemäß einer zweiten Ausführungsform mit einer zweiteiligen Ausleseschaltung, und
- Fig. 5: einen erfindungsgemäßen Bildsensor gemäß einer Variante der ersten Ausführungsform aus Fig. 3.

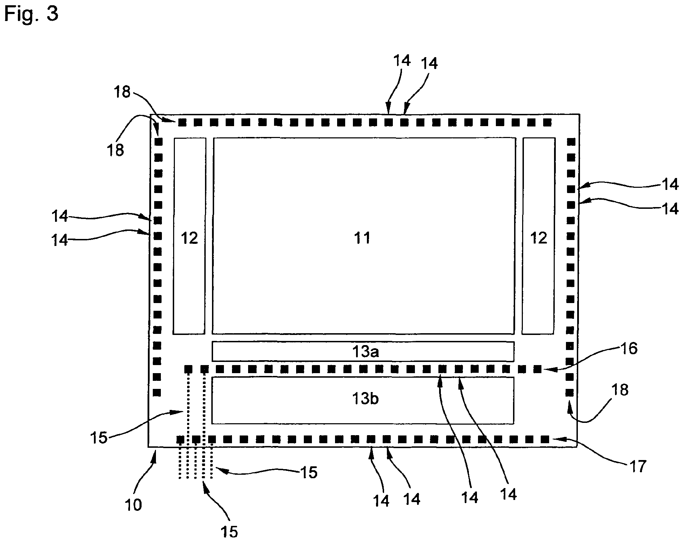

Der in Fig. 3 gezeigte Bildsensor 10 gemäß einer ersten Ausführungsform umfasst - in Analogie zu dem aus dem Stand der Technik bekannten Bildsensor gemäß Fig. 1 - eine Vielzahl von in Zeilen und Spalten angeordneten Pixeln, die jeweils ein einer Belichtung proportionales Signal erzeugen und zusammen ein zweidimensionales Bildfeld oder Pixelfeld 11 bilden. Ferner umfasst der Bildsensor 10 eine zweigeteilte Zeilenauswahlschaltung oder Ansteuerschaltung 12, eine Ausleseschaltung 13 und optional auch eine nicht dargestellte Ablaufsteuerung. Darüber hinaus sind eine Vielzahl von Bondpads 14 vorgesehen, die mit Ein- und Ausgängen der vorgenannten Schaltungsteile verbunden sind, um dem Bildsensor 10 über die Bondpads 14 externe Steuersignale zuzuführen, um Pixelsignale nach extern auszugeben, und um den Bildsensor 10 mit einer Betriebsspannung und einem Referenzpotential, nämlich Masse, zu versorgen.

Die Zeilenauswahlschaltung 12 und die Ausleseschaltung 13 sind jeweils mit dem Pixelfeld 11 gekoppelt, wobei die beiden Teile der Zeilenauswahlschaltung 12 jeweils in Längsrichtung der Zeilen oder von Zeilenleitungen des Pixelfelds 11 angeordnet sind und die Ausleseschaltung 13 in Längsrichtung der Spalten oder von Spaltenleitungen des Pixelfelds 11 angeordnet ist. Die Ausleseschaltung 13 erstreckt sich bevorzugt über die gesamte Breite des Bildfelds 11, d.h. über sämtliche Spalten oder Spaltenleitungen.

Die Ausleseschaltung 13 des Bildsensors 10 gemäß Fig. 3 umfasst einen ersten Abschnitt 13a und einen zweiten Abschnitt 13b, wobei der zweite Abschnitt 13b dem ersten Abschnitt 13a in Signalausleserichtung nachgeordnet ist, wie dies bereits vorstehend zum Stand der Technik erläutert wurde. Der erste Abschnitt 13a der Ausleseschaltung 13 ist zum zeilenweisen Auslesen der Signale der Pixel des Bildfelds 11 ausgelegt und umfasst für jede der Spalten des Bildfelds 11 einen Sample-and-Hold Schaltkreis zum Speichern des Signals des Pixels der jeweiligen ausgelesenen Zeile sowie eine Spaltenverstärkereinrichtung zum Verstärken des jeweiligen Signals.

Der zweite Abschnitt 13b der Ausleseschaltung 13 umfasst eine Multiplexereinrichtung, um die ausgelesenen Signale einer jeweiligen Zeile, die in dem ersten Abschnitt 13a der Ausleseschaltung 13 anliegen, nacheinander oder sequentiell an wenigstens einem Ausgang der Ausleseschaltung 13 auszugeben. Insbesondere umfasst die Ausleseschaltung 13 mehrere derartige Ausgänge, so dass gleichzeitig oder parallel mehrere ausgelesene Signale einer jeweiligen Zeile, d.h. Gruppen von ausgelesenen Signale, ausgegeben werden. Ferner kann der zweite Abschnitt 13b der Ausleseschaltung 13 einen oder mehrere Analog-Digital-Wandler aufweisen, um die ausgelesenen Signale, noch bevor sie an eine externe Einrichtung ausgegeben werden, zu digitalisieren. Außerdem kann der zweite Abschnitt 13b einen oder mehrere Ausgangsverstärker umfassen, um die ausgelesenen Signale zu verstärken, bevor sie an eine externe Einrichtung ausgegeben werden.

Der erste Abschnitt 13a der Ausleseschaltung 13 arbeitet mit einer ersten Taktfrequenz, nämlich dem Zeilentakt, und der zweite Abschnitt 13b der Ausleseschaltung 13 arbeitet mit einer zweiten Taktfrequenz, nämlich dem Pixeltakt. Da in dem ersten Abschnitt 13a der Ausleseschaltung 13 die Signale der Pixel einer gesamte Zeile gleichzeitig verarbeitet werden und in dem zweiten Abschnitt 13b der Ausleseschaltung 13 hingegen jeweils immer nur ein einzelnes derartiges Signal oder eine insbesondere kleine Gruppe von Signalen verarbeitet wird, arbeitet der zweite Abschnitt 13b der Ausleseschaltung 13 mit einer höheren Taktfrequenz als der erste Abschnitt 13a der Ausleseschaltung 13.

Im Gegensatz zu dem Bildsensor 10 gemäß Fig. 1, bei dem der erste und der zweite Abschnitt der Ausleseschaltung 13 unmittelbar aneinander angrenzen, so dass die beiden Abschnitte der Ausleseschaltung 13 in Fig. 1 folglich auch als einheitlicher Block 13 dargestellt sind, ist bei dem in Form eines Halbleiter-Chips vorliegenden Bildsensor gemäß Fig. 3 zwischen den beiden Abschnitten 13a, 13b der Ausleseschaltung 13 eine innere Bondpadreihe 16 aus einer Vielzahl einzelner, äquidistanter Bondpads 14 angeordnet, wobei die beiden Abschnitte 13a, 13b der Ausleseschaltung 13 auf derselben Seite des Bildfelds 11 angeordnet sind.

Bei den Bondpads 14 der inneren Bondpadreihe 16 handelt es sich ausschließlich um Bondpads 14, die zur Vorsorgung der beiden Abschnitte 13a, 13b der Ausleseschaltung 13 des Bildsensors 10 bzw. Bildsensor-Chips oder Halbleiter-Chips mit der Betriebsspannung und Masse vorgesehen sind. Natürlich kann die innere Bondpadreihe 16 aber auch Bondpads 14 enthalten, die eine andere Funktion erfüllen.

Durch diese Maßnahme und die damit verbundene zumindest weitgehende gegenseitige Abschirmung und Entkopplung der beiden Abschnitte 13a, 13b der Ausleseschaltung 13 voneinander können Störungen des Betriebs des ersten Abschnitts 13a der Ausleseschaltung 13 durch den gleichzeitigen Betrieb des zweiten Abschnitts 13b und umgekehrt weitgehend vermieden werden. Die vorgenannte gegenseitige Abschirmung, insbesondere elektromagnetische Abschirmung, kann insbesondere dadurch erzielt werden, dass die betreffenden Bondpads 14 und die hiermit verbundenen Bonddrähte auf einem konstanten elektrischen Potential liegen.

Eine derartige Störung könnte ansonsten dadurch entstehen, dass es aufgrund eines während des Betriebs schwankenden Strombedarfs eines der beiden Abschnitte 13a, 13b der Ausleseschaltung 13 in Kombination mit hohen elektrischen Widerständen der die jeweilige Versorgung gewährleistenden Leiterbahnen zu den jeweiligen anderen Abschnitt 13b, 13a beeinflussenden Schwankungen der Betriebsspannung und des Referenzpotentials kommen kann. Eine derartige Störung wäre insbesondere deshalb wahrscheinlich, da die beiden Abschnitte 13a, 13b der Ausleseschaltung 13 mit stark unterschiedlichen Taktfrequenzen betrieben werden.

Durch die Anordnung der inneren Bondpadreihe 16 in unmittelbarer Nähe zu beiden Abschnitten 13a, 13b der Ausleseschaltung 13 können die Versorgungsleitungen zu beiden Abschnitten 13a, 13b zudem jeweils relativ kurz gehalten werden, so dass die vorgenannten Schwankungen bereits in lediglich vermindertem Ausmaß auftreten. Die Abschnitte 13a, 13b der Ausleseschaltung 13 sind dabei jeweils über eigene Leiterbahnen mit den Bondpads 14 der Bondpadreihe 16 verbunden.

Die elektrische Verbindung dieser Bondpads 14 über Leiterbahnen mit den Ein- und Ausgängen der beiden Abschnitte 13a, 13b der Ausleseschaltung 13 ist dabei vorzugsweise derart gewählt, dass für die beiden Abschnitte 13a, 13b separate Bondpads 14 vorgesehen sind, d.h. zumindest einige und vorzugsweise sämtliche der vorgenannten Bondpads 14 für die Versorgung der Ausleseschaltung 13 mit der Betriebsspannung und Masse sind jeweils entweder nur mit dem ersten Abschnitt 13a der Ausleseschaltung 13 oder nur mit dem zweiten Abschnitt 13b verbunden.

Für den gesamten ersten Abschnitt 13a der Ausleseschaltung 13 ist nicht nur ein die Betriebsspannung bereitstellendes Bondpad 14 und nicht nur ein das Referenzpotential bereitstellendes Bondpad 14 vorgesehen, sondern es sind jeweils mehrere Bondpads 14 vorgesehen, wobei beispielsweise für je 20-50 Spalten ein eigenes Bondpad 14 für die Betriebsspannung und ein eigenes Bondpad 14 für Masse vorgesehen ist. Hierdurch können quer durch das gesamte Bild verlaufende helle Streifen vermieden werden, wie dies vorstehend bereits erläutert ist.

Neben der inneren Bondpadreihe 16 ist eine äußere Bondpadreihe 17 mit äquidistanten Bondpads 14 vorgesehen, die auf der der Bondpadreihe 16 gegenüberliegenden Seite des zweiten Abschnitts 13b der Ausleseschaltung 13 und damit am unteren Bildsensorrand angeordnet ist. Bei den Bondpads 14 der äußeren Bondpadreihe 17 kann es sich beispielsweise um Bondpads 14 handeln, die zum Empfangen von Steuersignalen für die verschiedenen Schaltungsteile des Bildsensors 10 und/oder zum Ausgeben der gegebenenfalls verstärkten Pixelsignale der Ausleseschaltung 13 vorgesehen sind. Grundsätzlich können unter den Bondpads 14 der äußeren Bondpadreihe 17 aber auch ein oder mehrere Bondpads 14 zu finden sein, die die Betriebsspannung und/oder Masse zur Verfügung stellen und/oder jeweils mit nur einem der beiden Abschnitte 13a, 13b der Ausleseschaltung 13 verbunden sind. Neben der vorgenannten äußeren Bondpadreihe 17 sind weitere äußere Bondpadreihen 18 vorgesehen, so dass der Bildsensor 10 am äußeren Rand umlaufend mit Bondpadreihen 17, 18 versehen ist.

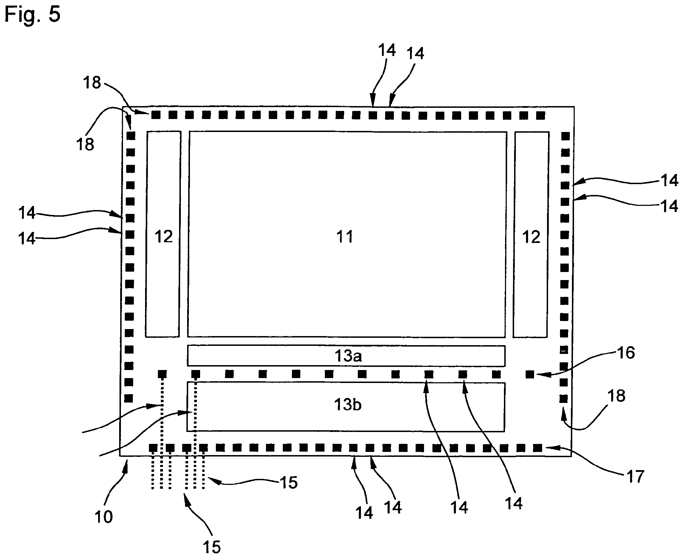

Die Bondpads 14 der äußeren Bondpadreihe 17 und die Bondpads 14 der inneren Bondpadreihe 16 besitzen üblicherweise dieselben Abstände zueinander. Die äußere Bondpadreihe 17 ist gegenüber der inneren Bondpadreihe 16 um einen halben derartigen Abstand versetzt. Dies ermöglicht, dass Bonddrähte 15, die auf die Bondpads 14 der inneren Bondpadreihe 16 gebondet werden, zwischen den Bonddrähten 15, die auf die Bondpads 14 der äußeren Bondpadreihe 17 gebondet werden, hindurch verlaufen können. In Fig. 5 ist eine Alternative zu der in Fig. 3 dargestellten ersten Ausführungsform gezeigt, bei welcher Alternative gegenüber Fig. 3 nur jedes zweite Bondpad 14 der inneren Bondpadreihe 16 vorgesehen ist, d.h. die innere Bondpadreihe 16 der Alternative weist gegenüber Fig. 3 nur das halbe Raster auf, wobei auch in diesem Fall die Bonddrähte 15 der inneren Bondpadreihe 16 zwischen den Bonddrähten 15 der äußeren Bondpadreihe 17 geführt werden können.

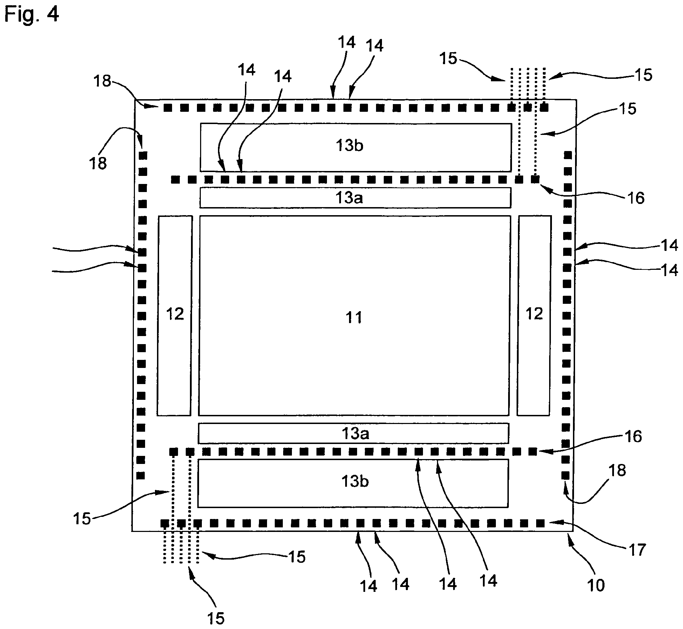

In Fig. 4 ist ein Bildsensor 10 gemäß einer zweiten Ausführungsform gezeigt. Der Bildsensor 10 gemäß Fig. 4 unterscheidet sich von dem Bildsensor 10 gemäß Fig. 3 dadurch, dass die Ausleseschaltung 13 zwei Teile aufweist, von denen der eine Teil oberhalb des Bildfelds 11 und der andere Teil unterhalb des Bildfelds 11 angeordnet ist. Eine derartige Aufteilung wird dann verwendet, wenn das Bildfeld 11 zweigeteilt ist und eine obere Hälfte des Bildfelds 11 durch den oberen Teil der Ausleseschaltung 13 und die untere Hälfte des Bildfelds 11 durch den unteren Teil der Ausleseschaltung 13 ausgelesen wird. Jeder der beiden Teile der Ausleseschaltung 13 besitzt dann einen vorgenannten ersten Abschnitt 13a und einen vorgenannten zweiten Abschnitt 13b, und für jeden der beiden Teile der Ausleseschaltung 13 ist eine eigene innere Bondpadreihe 16 vorgesehen.

Durch die vorliegende Erfindung kann eine gegenseitige negative Beeinflussung der beiden insbesondere mit verschiedenen Geschwindigkeiten arbeitenden Abschnitte einer Ausleseschaltung eines Bildsensors zumindest weitgehend vermieden werden.

### Bezugszeichenliste

- 10: Bildsensor
- 11: Bildfeld
- 12: Zeilenauswahlschaltung
- 13: Ausleseschaltung
- 13a: erster Abschnitt der Ausleseschaltung
- 13b: zweiter Abschnitt der Ausleseschaltung
- 14: Bondpad
- 15: Bonddraht
- 16: innere Bondpadreihe
- 17: äußere Bondpadreihe
- 18: weitere äußere Bondpadreihe

## Patentansprüche

1. Bildsensor für elektronische Kameras, der in Form eines Halbleiter-Chips eine Vielzahl von lichtempfindlichen Pixeln zur Erzeugung von belichtungsproportionalen Signalen und wenigstens eine mit den Pixeln gekoppelte Ausleseschaltung (13a, 13b) mit einem ersten Abschnitt (13a) und mit einem dem ersten Abschnitt (13a) in einer Signalausleserichtung nachgeschalteten zweiten Abschnitt (13b) umfasst, wobei der erste Abschnitt (13a) und der zweite Abschnitt (13b) der Ausleseschaltung (13a, 13b) jeweils mit wenigstens einem zur Versorgung mit einer Betriebsspannung vorgesehenen Bondpad (14) und/oder mit wenigstens einem zur Versorgung mit einem Referenzpotential vorgesehenen Bondpad (14) verbunden sind,
**dadurch gekennzeichnet,**
**dass** wenigstens einige der zur Versorgung der Ausleseschaltung (13a, 13b) mit der Betriebsspannung und/oder dem Referenzpotential vorgesehenen Bondpads (14) zwischen dem ersten Abschnitt (13a) und dem zweiten Abschnitt (13b) der Ausleseschaltung (13a, 13b) angeordnet sind.

2. Bildsensor nach Anspruch 1,
wobei der Bildsensor (10) dazu ausgelegt ist, den ersten Abschnitt (13a) der Ausleseschaltung (13a, 13b) mit einer ersten Taktfrequenz und den zweiten Abschnitt (13b) mit einer zweiten Taktfrequenz zu betreiben, wobei die zweite Taktfrequenz höher ist als die erste Taktfrequenz.

3. Bildsensor nach Anspruch 1 oder 2,
wobei die Pixel in wenigstens einer Zeile und in Spalten angeordnet sind, und wobei der erste Abschnitt (13a) der Ausleseschaltung (13a, 13b) dazu ausgelegt ist, die Signale der Pixel zeilenweise auszulesen, und der zweite Abschnitt (13b) dazu ausgelegt ist, die ausgelesenen Signale einer jeweiligen Zeile oder Gruppen von ausgelesenen Signalen einer jeweiligen Zeile nacheinander auszugeben.

4. Bildsensor nach zumindest einem der vorstehenden Ansprüche,
wobei der erste Abschnitt (13a) der Ausleseschaltung (13a, 13b) Sample-and-Hold-Schaltkreise und/oder Spaltenverstärker umfasst.

5. Bildsensor nach zumindest einem der vorstehenden Ansprüche,
wobei der zweite Abschnitt (13b) der Ausleseschaltung (13a, 13b) eine Multiplexerschaltung, wenigstens einen Analog-Digital-Wandler und/oder wenigstens einen Ausgangsverstärker umfasst.

6. Bildsensor nach zumindest einem der vorstehenden Ansprüche,
wobei die Pixel in wenigstens einer Zeile und in Spalten angeordnet sind, und wobei der erste Abschnitt (13a) und der zweite Abschnitt (13b) der Ausleseschaltung (13a, 13b) jeweils sich über die gesamte Länge einer Zeile und/oder sämtliche Spalten erstrecken.

7. Bildsensor nach zumindest einem der vorstehenden Ansprüche,
wobei der erste Abschnitt (13a) und/oder der zweite Abschnitt (13b) der Ausleseschaltung (13a, 13b) jeweils mit mehreren zur Versorgung mit der Betriebsspannung vorgesehenen Bondpads (14) und/oder mit mehreren zur Versorgung mit dem Referenzpotential vorgesehenen Bondpads (14) verbunden sind.

8. Bildsensor nach zumindest einem der vorhergehenden Ansprüche,
wobei sämtliche der zur Versorgung der Ausleseschaltung mit der Betriebsspannung und/oder dem Referenzpotential vorgesehenen Bondpads (14) zwischen dem ersten Abschnitt (13a) und dem zweiten Abschnitt (13b) der Ausleseschaltung (13a, 13b) angeordnet sind.

9. Bildsensor nach zumindest einem der vorstehenden Ansprüche,
wobei die Pixel in einem eindimensionalen oder zweidimensionalen Bildfeld (11) angeordnet sind, wobei der erste Abschnitt (13a) und der zweite Abschnitt (13b) der Ausleseschaltung (13a, 13b) auf derselben Seite des Bildfelds (11) benachbart zueinander angeordnet sind.

10. Bildsensor nach zumindest einem der vorstehenden Ansprüche,
wobei zumindest einige, bevorzugt sämtliche der vorgenannten wenigstens einigen der zur Versorgung der Ausleseschaltung mit der Betriebsspannung und/oder dem Referenzpotential vorgesehenen Bondpads (14) jeweils mit nur einem der beiden Abschnitte der Ausleseschaltung (13a, 13b) verbunden sind.

11. Bildsensor nach zumindest einem der vorstehenden Ansprüche,
wobei die Bondpads (14) entlang einer Bondpadreihe (16) angeordnet sind, bevorzugt zumindest im Wesentlichen äquidistant, wobei vorzugsweise sämtliche Bondpads (14) der Bondpadreihe (16) zur Versorgung mit der Betriebsspannung und/oder dem Referenzpotential vorgesehen sind.

12. Bildsensor nach Anspruch 11,
wobei eine weitere Bondpadreihe (17) mit zumindest im Wesentlichen äquidistanten Bondpads (14) vorgesehen ist,
wobei vorzugsweise die weitere Bondpadreihe (17) auf der von den Pixeln abgewandten Seite des zweiten Abschnitts (13b) der Ausleseschaltung (13a, 13b) angeordnet ist.

13. Bildsensor nach Anspruch 11 oder 12,
wobei die beiden Bondpadreihen (16, 17) gegeneinander versetzt sind.

14. Bildsensor nach zumindest einem der vorstehenden Ansprüche,
wobei die wenigstens einigen der zur Versorgung der Ausleseschaltung (13a, 13b) mit der Betriebsspannung und/oder dem Referenzpotential vorgesehenen Bondpads (14) durch den zweiten Abschnitt der Ausleseschaltung von einem Rand des Bildsensors beabstandet sind.

15. Bildsensor nach zumindest einem der vorstehenden Ansprüche,
wobei zwei Ausleseschaltungen (13a, 13b) vorgesehen sind, die bezüglich der Pixel auf einander gegenüberliegenden Seiten angeordnet sind, die jeweils gemäß zumindest einem der vorstehenden Ansprüche ausgebildet sind, und die jeweils gemäß zumindest einem der vorstehenden Ansprüche mit Bondpads (14) verbunden sind, und wobei für jede Ausleseschaltung (13a, 13b) eigene Bondpads (14) gemäß zumindest einem der vorstehenden Ansprüche vorgesehen sind.

## Claims

1. An image sensor for electronic cameras which, in the form of a semiconductor chip, comprises a plurality of light-sensitive pixels for the generation of signals proportional to exposure and at least one read-out circuit (13a, 13b) coupled to the pixels and having a first section (13a) and having a second section (13b) disposed downstream of the first section (13a) in a signal read-out direction, wherein the first section (13a) and the second section (13b) of the read-out circuit (13a, 13b) are each connected to at least one bond pad (14) provided for the supply of an operating voltage and/or to at least one bond pad (14) provided for the supply of a reference potential,
**characterized in that**
at least some of the bond pads (14) provided for the supply of the operating voltage and/or of the reference potential to the read-out circuit (13a, 13b) are arranged between the first section (13a) and the second section (13b) of the read-out circuit (13a, 13b).

2. An image sensor in accordance with claim 1,
wherein the image sensor (10) is configured to operate the first section (13a) of the read-out circuit (13a, 13b) at a first clock frequency and the second section (13b) at a second clock frequency, with the second clock frequency being higher than the first clock frequency.

3. An image sensor in accordance with claim 1 or claim 2,
wherein the pixels are arranged in at least one row and in columns; and wherein the first section (13a) of the read-out circuit (13a, 13b) is configured to read out the signals of the pixels row-wise and the second section (13b) is configured to output the read out signals of a respective row or groups of read out signals of a respective row sequentially.

4. An image sensor in accordance with at least one of the preceding claims,
wherein the first section (13a) of the read-out circuit (13a, 13b) includes sample-and-hold circuits and/or column amplifiers.

5. An image sensor in accordance with at least one of the preceding claims,
wherein the second section (13b) of the read-out circuit (13a, 13b) includes a multiplexer circuit, at least one analog-to-digital converter and/or at least one output amplifier.

6. An image sensor in accordance with at least one of the preceding claims,
wherein the pixels are arranged in at least one row and in columns; and wherein the first section (13a) and the second section (13b) of the read-out circuit (13a, 13b) each extend over the total length of a row and/or over all columns.

7. An image sensor in accordance with at least one of the preceding claims,
wherein the first section (13a) and/or the second section (13b) of the read-out circuit (13a, 13b) are each connected to a plurality of bond pads (14) provided for the supply of the operating voltage and/or to a plurality of bond pads (14) provided for the supply of the reference potential.

8. An image sensor in accordance with at least one of the preceding claims,
wherein all of the bond pads (14) provided for the supply of the operating voltage and/or of the reference potential to the read-out circuit are arranged between the first section (13a) and the second section (13b) of the read-out circuit (13a, 13b).

9. An image sensor in accordance with at least one of the preceding claims,
wherein the pixels are arranged in a one-dimensional or two-dimensional image field (11), with the first section (13a) and the second section (13b) of the read-out circuit (13a, 13b) being arranged adjacent to one another at the same side of the image field (11).

10. An image sensor in accordance with at least one of the preceding claims,
wherein at least some, preferably all, of the aforesaid at least some of the bond pads (14) provided for the supply of the operating voltage and/or of the reference potential to the read-out circuit are each connected to only one of the two sections of the read-out circuit (13a, 13b).

11. An image sensor in accordance with at least one of the preceding claims,
wherein the bond pads (14) are arranged along a bond pad row (16), preferably at least essentially equidistant; and wherein all bond pads (14) of the bond pad row (16) are preferably provided for the supply of the operating voltage and/or of the reference potential.

12. An image sensor in accordance with claim 11,
wherein a further bond pad row (17) with at least substantially equidistant bond pads (14) is provided; and wherein the further bond pad row (17) is preferably arranged on the side of the second section (13b) of the read-out circuit (13a, 13b) remote from the pixels.

13. An image sensor in accordance with claim 11 or claim 12,
wherein the two bond pad rows (16, 17) are offset with respect to one another.

14. An image sensor in accordance with at least one of the preceding claims,
wherein the at least some of the bond pads (14) provided for the supply of the operating voltage and/or of the reference potential to the read-out circuit (13a, 13b) are spaced apart from a margin of the image sensor by the second section of the read-out circuit.

15. An image sensor in accordance with at least one of the preceding claims,
wherein two read-out circuits (13a, 13b) are provided which are arranged on mutually oppositely disposed sides with respect to the pixels, which are each designed in accordance with at least one of the preceding claims and which are each connected to bond pads (14) in accordance with at least one of the preceding claims; and wherein separate bond pads (14) in accordance with at least one of the preceding claims are provided for each read-out circuit (13a, 13b).

## Revendications

1. Capteur d'image pour caméra électronique, qui comprend une multitude de pixels photosensibles sous la forme d'une puce semiconductrice pour générer des signaux proportionnels à l'illumination et au moins un circuit de lecture (13a, 13b) couplé aux pixels, comportant une première portion (13a) et une seconde portion (13b) disposée en aval de la première portion (13a) dans une direction de lecture de signal, la première portion (13a) et la seconde portion (13b) du circuit de lecture (13a, 13b) étant connectée chacune à au moins un plot de bonding (14) prévu pour l'alimentation avec une tension de fonctionnement et/ou à au moins plot de bonding (14) prévu pour l'alimentation avec un potentiel de référence,
**caractérisé en ce que**
quelques-uns au moins des plots de bonding (14) prévus pour l'alimentation du circuit de lecture (13a, 13b) avec la tension de fonctionnement et/ou le potentiel de référence sont agencés entre la première portion (13a) et la seconde portion (13b) du circuit de lecture (13a, 13b).

2. Capteur d'image selon la revendication 1,
dans lequel le capteur d'image (10) est conçu pour faire fonctionner la première portion (13a) du circuit de lecture (13a, 13b) à une première fréquence de cycle et la seconde portion (13b) à une seconde fréquence de cycle, la seconde fréquence de cycle étant supérieure à la première fréquence de cycle.

3. Capteur d'image selon la revendication 1 ou 2,
dans lequel les pixels sont disposés en au moins une ligne et en colonnes, et la première portion (13a) du circuit de lecture (13a, 13b) est conçue pour lire les signaux des pixels par ligne, et la seconde portion (13b) est conçue pour émettre successivement les signaux lus d'une ligne respective ou des groupes de signaux lus d'une ligne respective.

4. Capteur d'image selon l'une au moins des revendications précédentes, dans lequel la première portion (13a) du circuit de lecture (13a, 13b) comprend des circuits électroniques "sample-and-hold" (d'échantillonnage et de maintien) et/ou des amplificateurs de colonne.

5. Capteur d'image selon l'une au moins des revendications précédentes, dans lequel la seconde portion (13b) du circuit de lecture (13a, 13b) comprend un circuit multiplexeur, au moins un convertisseur analogique-numérique et/ou au moins un amplificateur de sortie.

6. Capteur d'image selon l'une au moins des revendications précédentes, dans lequel les pixels sont disposés en au moins une ligne et en colonnes, et la première portion (13a) et la seconde portion (13b) du circuit de lecture (13a, 13b) s'étendent chacune sur toute la longueur d'une ligne et/ou sur toutes les colonnes.

7. Capteur d'image selon l'une au moins des revendications précédentes, dans lequel la première portion (13a) et/ou la seconde portion (13b) du circuit de lecture (13a, 13b) sont connectées chacune à plusieurs plots de bonding (14) prévus pour l'alimentation avec la tension de fonctionnement et/ou à plusieurs plots de bonding (14) prévus pour l'alimentation avec le potentiel de référence.

8. Capteur d'image selon l'une au moins des revendications précédentes, dans lequel tous les plots de bonding (14) prévus pour l'alimentation du circuit de lecture avec la tension de fonctionnement et/ou avec le potentiel de référence sont agencés entre la première portion (13a) et la seconde portion (13b) du circuit de lecture (13a, 13b).

9. Capteur d'image selon l'une au moins des revendications précédentes, dans lequel les pixels sont disposés dans un champ d'image (11) monodimensionnelle ou bidimensionnelle, et la première portion (13a) et la seconde portion (13b) du circuit de lecture (13a, 13b) sont disposées au voisinage l'une de l'autre sur le même côté du champ d'image (11).

10. Capteur d'image selon l'une au moins des revendications précédentes, dans lequel au moins quelques-uns, de préférence tous lesdits au moins quelques plots de bonding (14) prévus pour l'alimentation du circuit de lecture avec la tension de fonctionnement et/ou avec le potentiel de référence sont reliés chacun à une seule des deux portions du circuit de lecture (13a, 13b).

11. Capteur d'image selon l'une au moins des revendications précédentes, dans lequel les plots de bonding (14) sont agencés le long d'une rangée (16) de plots de bonding, de préférence de façon au moins sensiblement équidistante, et de préférence tous les plots de bonding (14) de la rangée (16) de la rangée (16) de plots de bonding sont prévus pour l'alimentation avec la tension de fonctionnement et/ou avec le potentiel de référence.

12. Capteur d'image selon la revendication 11, dans lequel il est prévu au moins une autre rangée (17) de plots de bonding avec des plots de bonding (14) au moins sensiblement équidistants, et de préférence l'autre rangée (17) de plots de bonding est agencée sur le côté de la seconde portion (13b) du circuit de lecture (13a, 13b) détourné par rapport aux pixels.

13. Capteur d'image selon la revendication 11 ou 12,
dans lequel les deux rangées (16, 17) de plots de bonding sont décalées l'une par rapport à l'autre.

14. Capteur d'image selon l'une au moins des revendications précédentes, dans lesdits au moins quelques plots de bonding (14) prévus pour l'alimentation du circuit de lecture (13a, 13b) avec la tension de fonctionnement et/ou avec le potentiel de référence sont écartés d'un bord du capteur d'image par la seconde portion du circuit de lecture.

15. Capteur d'image selon l'une des revendications précédentes, dans lequel sont prévus deux circuits de lecture (13a, 13b) qui sont agencés sur des côtés opposés l'un à l'autre par rapport aux pixels et qui sont réalisés selon l'une au moins des revendications précédentes et qui sont reliés chacun à des plots de bonding (14) selon l'une au moins des revendications précédentes, et pour chaque circuit de lecture (13a, 13b) sont prévus quelques plots de bonding (14) selon l'une au moins des revendications précédentes.
